# DEMANDE DE BREVET EUROPEEN

(11) **EP 3 832 719 A1**
(43) Date de publication de la demande: **09.06.2021**
(21) Numéro de dépôt: 20210092.1
(22) Date de dépôt: 26.11.2020
(51) Int. Cl.: H01L 27/02, H01L 27/06, H01L 27/11, H01L 21/822, G11C 5/02, G11C 11/412, G11C 11/417, G11C 11/418, H01L 27/12

(54) **DISPOSITIF MEMOIRE 3D COMPRENANT DES CELLULES MEMOIRES DE TYPE SRAM A POLARISATION ARRIERE AJUSTABLE**

(30) Priorité: 03.12.2019 FR 1913651
(71) Demandeur: Commissariat à l'énergie atomique et aux énergies alternatives, 75015 Paris (FR)
(72) Inventeur: MAKOSIEJ, Adam, 38054 GRENOBLE CEDEX 09 (FR); GIRAUD, Bastien, 38054 GRENOBLE CEDEX 09 (FR); NOEL, Jean-Philippe, 38054 GRENOBLE CEDEX 09 (FR)
(74) Mandataire: Brevalex

(57) **Abrégé**

Dispositif mémoire (100) comprenant :
- une matrice (102) de cellules mémoires comportant des transistors FET incluant des éléments de polarisation arrière, dont au moins une colonne (104.1, 104.2) forme des bits de polarisation arrière ;
- un circuit de polarisation arrière (106) délivrant des tensions dépendantes des bits de polarisation arrière ;
- des premiers et deuxièmes éléments de couplage (108, 110), couplant des points mémoires des bits de polarisation arrière avec le circuit de polarisation arrière, et le circuit de polarisation arrière avec les éléments de polarisation arrière des cellules de la matrice ;
dans lequel :
- le dispositif forme un circuit 3D comprenant des première et deuxième couches actives entre lesquelles plusieurs couches d'interconnexions sont empilées ;
- les premiers et/ou deuxièmes éléments de couplage comportent des portions métalliques d'une des couches d'interconnexions.

## Description

### DOMAINE TECHNIQUE

L'invention concerne un dispositif mémoire 3D (trois dimensions), c'est-à-dire réalisé sous la forme d'un circuit comprenant plusieurs couches actives, ou plusieurs niveaux de composants électroniques, superposées, et comprenant des cellules mémoires. L'invention peut s'appliquer à des dispositifs formant une ou plusieurs mémoires SRAM (« Static Random Access Memory », ou mémoire vive statique), mais également des dispositifs formant une ou plusieurs mémoires CAM (« Content-Addressable Memory », ou mémoire adressable par contenu), TCAM (« Ternary Content-Addressable Memory », ou mémoire adressable par contenu ternaire) ou DRAM (« Dynamic Random Access Memory », ou mémoire vive dynamique) ou ROM (« Read Only Memory »).

### ÉTAT DE LA TECHNIQUE ANTÉRIEURE

Pour la réalisation de dispositifs mémoires comprenant des cellules mémoires telles que des cellules mémoires de type SRAM, il est avantageux d'utiliser des transistors FET (« Field-Effect Transistor », ou transistor à effet de champ) dont la polarisation arrière peut être ajustée. Avec de tels transistors utilisés pour former les cellules mémoires, il est possible d'ajuster le rapport performance / consommation électrique de ces cellules mémoires en fonction des besoins et des contraintes imposées aux dispositifs mémoires.

Des bits de commande de polarisation arrière, dont les valeurs sont représentatives des niveaux des tensions de polarisation arrière à appliquer aux transistors, sont généralement stockés dans des verrous, ou des bascules, ou encore des cellules OTP (« One Time Programmable », ou programmable une seule fois) / MTP (« Multi time Programmable », ou programmable plusieurs fois) pour permettre un accès rapide à ces bits. Le problème qui se pose est que ces éléments occupent une surface importante de la couche active, ce qui limite le nombre de verrous, bascules ou cellules réalisables étant donné la faible surface de couche active disponible dans le dispositif mémoire. Par conséquent, cela empêche la réalisation d'un dispositif mémoire dans lequel la polarisation arrière des transistors des cellules mémoires serait ajustée pour chaque cellule mémoire.

De plus, dans les dispositifs mémoires standards comprenant des cellules mémoires réalisées en technologie CMOS, c'est-à-dire comprenant des transistors MOSFET, les caissons de semi-conducteur dopé des transistors sur lesquels les tensions de polarisation sont appliquées sont tels que chaque caisson soit commun à toutes les cellules mémoires d'une même colonne, et éventuellement commun aux cellules mémoires de deux colonnes adjacentes. Une réalisation des caissons de semi-conducteur dopé tels que chaque caisson soit commun à toutes les cellules mémoires d'une même ligne est possible, mais cela engendre une augmentation de la surface occupée par chacune des cellules mémoires. Dans tous les cas, ces configurations des caissons limitent les possibilités d'ajustement des tensions de polarisation arrière des transistors des cellules mémoires.

### EXPOSÉ DE L'INVENTION

Un but de la présente invention est de proposer un dispositif mémoire dans lequel une polarisation arrière ajustable des transistors des cellules mémoires est mise en œuvre de manière efficace, c'est-à-dire sans augmentation importante de la surface de couche active occupée et de la consommation électrique.

Pour cela, il est proposé un dispositif mémoire comprenant au moins :
- une matrice de plusieurs lignes et colonnes de cellules mémoires formant des bits de mémorisation de données, chacune des cellules mémoires comportant des transistors FET incluant au moins un élément électriquement conducteur de polarisation arrière, la matrice comprenant en outre au moins une colonne de cellules mémoires formant des premiers bits de commande de polarisation arrière ;
- un premier circuit de polarisation arrière configuré pour délivrer en sortie des premières tensions de polarisation arrière dont les valeurs dépendent de celles des premiers bits de commande de polarisation arrière ;
- des premiers éléments de couplage, couplant électriquement des points mémoires des cellules mémoires formant les premiers bits de commande de polarisation arrière avec le premier circuit de polarisation arrière ;
- des deuxièmes éléments de couplage, couplant électriquement le premier circuit de polarisation arrière avec les éléments électriquement conducteurs de polarisation arrière des cellules mémoires formant les bits de mémorisation de données ;
et dans lequel :
- le dispositif mémoire forme un circuit 3D comprenant au moins des première et deuxième couches actives semi-conductrices entre lesquelles plusieurs couches métalliques d'interconnexions sont empilées ;
- la matrice de cellules mémoires est réalisée dans la deuxième couche active, et le premier circuit de polarisation arrière est réalisé dans au moins l'une des première et deuxième couches actives ;
- les premiers et/ou deuxièmes éléments de couplage comportent des portions métalliques d'au moins une des couches métalliques d'interconnexions.

Avec un tel dispositif mémoire, il est possible de réaliser une correction précise des opérations de mémorisation, de lecture et/ou d'écriture, ou de comparaison de données, mises en œuvre en choisissant des valeurs adéquates des tensions de polarisation arrière, ces valeurs étant définies par les valeurs mémorisées dans les premiers bits de commande de polarisation arrière.

Par exemple, il est possible d'accélérer localement une opération de lecture ou d'écriture mise en œuvre dans une ou plusieurs lignes de cellules mémoires trop lentes par rapport aux autres lignes de cellules mémoires, et/ou de ralentir une telle opération mise en œuvre dans une ou plusieurs lignes de cellules mémoires trop rapides par rapport aux autres lignes de cellules mémoires, et obtenir ainsi de bonnes performances avec une consommation électrique minimale. Cela correspond au cas d'une polarisation statique dans laquelle une polarisation constante est appliquée indépendamment pour chaque ligne de cellules mémoires au cours d'un mode de fonctionnement actif ou d'attente (« standby mode ») du dispositif mémoire. Il est également possible de réaliser une polarisation sélective et statique, différente pour les modes actifs et d'attente, et qui change de manière globale, c'est-à-dire pour toutes les cellules mémoires, entre ces modes en fonction des états de polarisation.

Ce dispositif mémoire permet également de choisir, pour une ou plusieurs cellules mémoires et indépendamment des autres cellules mémoires, un état de polarisation arrière adéquate parmi plusieurs états de polarisation arrière possibles, en fonction de l'opération à exécuter. Ces états de polarisation peuvent être appliqués indépendamment pour chaque ligne de cellules mémoires, en fonction du rapport consommation/performances recherché.

La réalisation du dispositif mémoire sous la forme d'un circuit 3D permet d'utiliser les couches métalliques d'interconnexions se trouvant entre les première et deuxième couches actives pour former les premiers et/ou deuxièmes éléments de couplage. Cette configuration est avantageuse car elle n'impacte ni l'architecture du dispositif mémoire ni ses fonctionnalités du fait qu'elle n'ajoute aucun couplage capacitif vis-à-vis des signaux du circuit mémoire.

De plus, la réalisation du dispositif mémoire sous la forme d'un circuit 3D permet de réaliser des connexions aux éléments électriquement conducteurs de polarisation arrière des transistors des cellules mémoires qui soient indépendantes pour chaque transistor ou pour plusieurs transistors, dans une cellule mémoire, sans coût de surface.

De plus, ce dispositif mémoire permet d'avoir plusieurs valeurs de tensions de polarisation arrière, ce qui permet d'obtenir une bonne flexibilité dans l'ajustement du point de fonctionnement du dispositif mémoire en fonction du rapport consommation/performance recherché.

Les états des premiers bits de commande de polarisation arrière peuvent être utilisés comme valeurs de commande pour le premier circuit de polarisation arrière qui génère alors les tensions de polarisation avec des valeurs définies par les états des premiers bits de commande de polarisation arrière, ou peuvent être utilisés comme valeurs de sélection permettant de choisir une parmi plusieurs tensions de polarisation (qui peuvent correspondre uniquement à la tension d'alimentation VDD et la masse) fournies en entrée du premier circuit de polarisation arrière.

Les cellules mémoires de la matrice peuvent être de type SRAM, ou CAM, ou TCAM, ou DRAM, ou ROM. De manière générale, chaque cellule mémoire comporte au moins un élément de mémorisation (par exemple deux inverseurs à transistors FET couplés de façon croisée pour une cellule mémoire de type SRAM, CAM ou TCAM, ou une capacité pour une cellule mémoire de type DRAM, ou d'autres types d'éléments pour des cellules mémoires non-volatiles) pour stocker et maintenir une donnée, et au moins un transistor FET utilisé pour accéder à l'élément de mémorisation et/ou pour réaliser une comparaison de données.

Le dispositif mémoire peut être tel que :
- les premiers éléments de couplage comportent des portions métalliques d'une des couches métalliques d'interconnexions appelée dernière couche métallique d'interconnexions et qui correspond à celle, parmi lesdites couches métalliques d'interconnexions, qui est la plus proche de la deuxième couche active, et les deuxièmes éléments de couplage comportent des portions métalliques d'une des couches métalliques d'interconnexions appelée avant-dernière couche métallique d'interconnexions et qui est disposée entre la dernière couche métallique d'interconnexions et toutes les autres couches métalliques d'interconnexions, ou
- les premiers et deuxièmes éléments de couplage comportent des portions métalliques de la dernière couche métallique d'interconnexions

Le choix entre l'une ou l'autre des deux configurations indiquées ci-dessus peut dépendre notamment du nombre d'éléments de couplage associés à chaque ligne de cellules mémoires, et du nombre de premiers bits de commande de polarisation arrière associés à chaque ligne de cellules mémoires.

De manière avantageuse, les éléments électriquement conducteurs de polarisation arrière peuvent être indépendants d'une ligne de cellules mémoires à l'autre. Ainsi, il est possible d'appliquer des tensions de polarisation arrière indépendantes pour chaque ligne de cellules mémoires.

Les éléments électriquement conducteurs de polarisation arrière peuvent comporter des caissons de semi-conducteur dopé. Le dispositif peut comporter en outre plusieurs lignes de mot telles que les cellules mémoires formant les bits de mémorisation de données et disposées sur une même ligne de la matrice comportent des transistors d'accès dont les grilles sont couplées à une même ligne de mot, et les caissons de semi-conducteur dopé selon un même type de conductivité et inclus dans des transistors de cellules mémoires d'une même ligne de la matrice peuvent être couplés électriquement entre eux et à au moins une sortie du premier circuit de polarisation arrière par au moins l'un des deuxièmes éléments de couplage tels qu'une même tension de polarisation arrière puisse être appliquée sur lesdits caissons de semi-conducteur dopé.

Les premiers bits de commande de polarisation arrière peuvent être formés par des cellules mémoires d'une ou plusieurs colonnes adjacentes formant un premier bord de la matrice à côté duquel est disposé le premier circuit de polarisation arrière. Une telle configuration permet de minimiser la surcharge de zone liée au stockage de ces premiers bits de commande de polarisation arrière.

Le dispositif mémoire peut être tel que :
- les cellules mémoires d'au moins une colonne formant un deuxième bord de la matrice qui est opposé au premier bord de la matrice correspondent à des bits de commande de fin de lecture dont les transistors d'accès sont couplés à au moins une ligne de mot distincte de celles auxquelles les transistors d'accès des cellules mémoires formant les bits de mémorisation sont couplés ;
- les cellules mémoires formant les bits de commande de fin de lecture sont couplées électriquement à un circuit de commande de fin de lecture des bits de mémorisation de données ;
- les caissons de semi-conducteur dopé selon un même type de conductivité et inclus dans les transistors des cellules mémoires formant les bits de commande de fin de lecture sont couplés électriquement entre eux par des troisièmes éléments de couplage comportant des portions métalliques d'au moins une des couches métalliques d'interconnexions.

Dans la configuration ci-dessus, il est possible d'ajuster de manière optimale le temps de lecture des bits de mémorisation de données via une mesure d'un temps de lecture obtenu en utilisant les bits de commande de fin de lecture.

Les portions métalliques des troisièmes éléments de couplage peuvent correspondre à des portions de la même couche métallique d'interconnexions que celle ou l'une de celles formant les portions métalliques des premiers et/ou deuxièmes éléments de couplage.

Le dispositif mémoire peut comporter en outre :
- au moins un bloc d'entrées/sorties auquel les colonnes des cellules mémoires formant les bits de mémorisation de données sont couplées électriquement ;
- un deuxième circuit de polarisation arrière configuré pour délivrer en sortie des deuxièmes tensions de polarisation arrière dont les valeurs dépendent de celles de deuxièmes bits de commande de polarisation arrière formés par au moins une ligne de la matrice ;
- des quatrièmes éléments de couplage, couplant électriquement des points mémoires des cellules mémoires formant les deuxièmes bits de commande de polarisation arrière avec le deuxième circuit de polarisation arrière, et comportant des portions métalliques de la même couche métallique d'interconnexions que celle ou l'une de celles formant les portions métalliques des premiers et/ou deuxièmes éléments de couplage ;
et dans lequel le deuxième circuit de polarisation arrière est couplé à des éléments électriquement conducteurs de polarisation arrière de transistors de type FET du bloc d'entrées/sorties.

Dans la configuration ci-dessus, il est possible de commander précisément la polarisation arrière de transistors du bloc d'entrées/sorties du dispositif mémoire. Il est ainsi possible d'optimiser le fonctionnement d'un ou plusieurs des circuits suivants faisant partie du bloc d'entrées/sorties : amplificateurs de lecture, circuits de pré-charge, pilotes d'écriture, multiplexeurs de colonnes, etc.

Les deuxièmes bits de commande de polarisation arrière peuvent être formés par des cellules mémoires d'une ou plusieurs lignes adjacentes formant un troisième bord de la matrice à côté duquel est disposé le deuxième circuit de polarisation arrière.

Les troisièmes éléments de couplage peuvent coupler électriquement les éléments électriquement conducteurs de polarisation arrière des transistors des cellules mémoires de ladite au moins une colonne formant le deuxième bord de la matrice avec le deuxième circuit de polarisation arrière.

### BRÈVE DESCRIPTION DES DESSINS

La présente invention sera mieux comprise à la lecture de la description d'exemples de réalisation donnés à titre purement indicatif et nullement limitatif en faisant référence aux dessins annexés sur lesquels :
- la figure 1 représente schématiquement un dispositif mémoire, objet de la présente invention, selon un premier mode de réalisation ;
- la figure 2 représente schématiquement une vue en coupe d'une partie du dispositif mémoire, objet de la présente invention, réalisé sous la forme d'un circuit 3D ;
- les figures 3 et 4 représentent schématiquement des exemples de réalisation d'éléments de couplage du dispositif mémoire, objet de la présente invention, selon le premier mode de réalisation ;
- la figure 5 représente un exemple de réalisation d'une cellule mémoire d'un dispositif mémoire, objet de la présente invention ;
- la figure 6 représente un exemple de réalisation de caissons de semi-conducteur dopé de polarisation arrière de transistors d'une cellule mémoire d'un dispositif mémoire, objet de la présent invention ;
- la figure 7 représente un exemple de réalisation particulier de caissons de semi-conducteur dopé de transistors de quatre cellules mémoires d'un dispositif mémoire, objet de la présente invention ;
- la figure 8 représente un autre exemple de réalisation particulier de caissons de semi-conducteur dopé de transistors de quatre cellules mémoires d'un dispositif mémoire, objet de la présente invention ;
- les figures 9 à 11 représentent plusieurs exemples de réalisation du dispositif mémoire selon le premier mode de réalisation ;
- la figure 12 représente schématiquement un dispositif mémoire, objet de la présente invention, selon un deuxième mode de réalisation ;
- les figures 13 et 14 représentent schématiquement des exemples de réalisation d'éléments de couplage du dispositif mémoire, objet de la présente invention, selon le deuxième mode de réalisation ;
- la figure 15 représente schématiquement un dispositif mémoire, objet de la présente invention, selon un troisième mode de réalisation ;
- la figure 16 représente schématiquement un exemple de couplage entre quatre colonnes de cellules mémoires et un bloc d'entrées/sorties d'un dispositif mémoire, objet de la présente invention ;
- les figures 17 à 19 représentent schématiquement des exemples de réalisation d'éléments de couplage du dispositif mémoire, objet de la présente invention, selon le troisième mode de réalisation.

Des parties identiques, similaires ou équivalentes des différentes figures décrites ci-après portent les mêmes références numériques de façon à faciliter le passage d'une figure à l'autre.

Les différentes parties représentées sur les figures ne le sont pas nécessairement selon une échelle uniforme, pour rendre les figures plus lisibles.

Les différentes possibilités (variantes et modes de réalisation) doivent être comprises comme n'étant pas exclusives les unes des autres et peuvent se combiner entre elles.

### EXPOSÉ DÉTAILLÉ DE MODES DE RÉALISATION PARTICULIERS

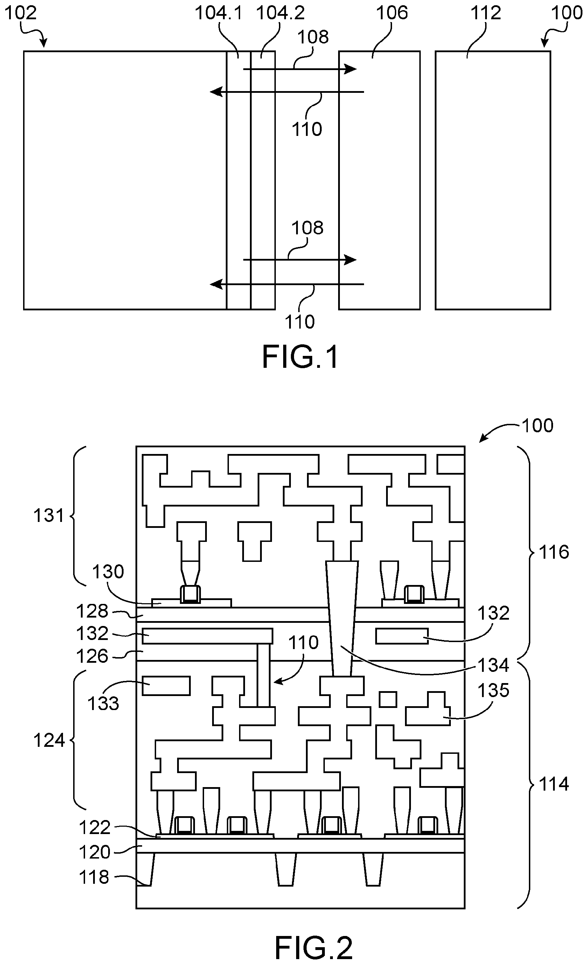

La figure 1 représente schématiquement un dispositif mémoire 100 selon un premier mode de réalisation.

Le dispositif mémoire 100 comporte une matrice 102 de plusieurs lignes et plusieurs colonnes de cellules mémoires. Dans le premier mode de réalisation décrit ici, les cellules mémoires sont de type SRAM. Chacune des cellules mémoires de type SRAM comporte par exemple 6 transistors FET ou MOSFET (cellule appelée dans ce cas 6T-SRAM). En variante, les cellules mémoires de la matrice 102 peuvent comporter plus ou moins de 6 transistors FET. Par exemple, les cellules mémoires de la matrice 102 peuvent correspondre aux cellules mémoires décrites dans au moins l'un des documents suivants : « 5T SRAM With Asymmetric Sizing for Improved Read Stability » de S. Nalam et al., IEEE Journal of Solid-State Circuits, Vol. 46, N°. 10, octobre 2011 ; « An 8T-SRAM for Variability Tolerance and Low-Voltage Operation in High-Performance Caches » de L. Chang et al., IEEE Journal of Solid-State Circuits, Vol. 43, N°. 4, avril 2008 ; « A 32 kb 10T Sub-Threshold SRAM Array With Bit-Interleaving and Differential Read Scheme in 90 nm CMOS » de I.J. Chang et al., IEEE Journal of Solid-State Circuits, Vol. 44, N°. 2, février 2009.

Chacune des cellules mémoires de la matrice 102 comporte des transistors FET de type N et P formant un point mémoire, ou nœud interne, dans lequel est stockée une valeur qui correspond à l'état bas ou l'état haut du bit formé par la cellule mémoire. Chaque cellule mémoire de la matrice 102 comporte également des transistors d'accès comportant chacun leur grille reliée à une ligne de mot, ou « word line », sur laquelle transite un signal commandant un accès en lecture ou en écriture aux cellules mémoires recevant ce signal. Dans la matrice 102, l'accès en écriture ou en lecture est réalisé ligne par ligne, chaque ligne de mot étant reliée aux grilles des transistors d'accès de cellules mémoires disposées sur une même ligne de la matrice 102. Les transistors d'accès sont également reliés à des lignes de bit, ou « bit lines », sur lesquelles transitent les données à mémoriser dans les cellules mémoires ou les données lues depuis les cellules mémoires. Les lignes de bit sont communes aux cellules mémoires disposées sur une même colonne de la matrice 102, c'est-à-dire que chaque ligne de bit est reliée à des cellules mémoires disposées sur une même colonne de la matrice.

Les transistors des cellules mémoires de la matrice 102 comportent des éléments électriquement conducteurs de polarisation arrière, correspondant par exemple à des caissons de semi-conducteur dopé, formant des plans de masse et permettant une polarisation arrière des transistors. Ces éléments électriquement conducteurs de polarisation arrière sont localisés sous les régions de canal de ces transistors. Par exemple, les transistors des cellules mémoires de la matrice 102 sont de type FDSOI (« Fully-Depleted Silicon-On-Insulator », ou silicium sur isolant totalement déserté), et les caissons de semi-conducteur dopé sont localisés sous les portions de diélectrique enterrées disposées sous les canaux des transistors.

Les cellules mémoires de la matrice 102 forment des bits de mémorisation de données dans lesquels des données envoyées en entrée du dispositif 100 sont mémorisées.

Les cellules mémoires d'une ou plusieurs colonnes 104 de la matrice 102 ne correspondent pas à des bits de mémorisation de données, mais à des bits de commande de polarisation arrière dans lesquels des états de polarisation arrière des cellules mémoires formant les bits de mémorisation de données sont mémorisés. Dans l'exemple de réalisation représenté sur la figure 1, deux colonnes de cellules mémoires, référencées 104.1 et 104.2, sont dédiées à la mémorisation de ces états de polarisation arrière.

La valeur codée dans le ou les bits de commande de polarisation arrière de la i^{ème} ligne de la matrice 102 est utilisée pour générer ou sélectionner une valeur d'une tension de polarisation arrière destinée à être appliquée sur les caissons de semi-conducteur dopé des transistors des cellules mémoires formant des bits de mémorisation de données et disposées sur la i^{ème} ligne de la matrice 102.

Le dispositif mémoire 100 comporte également un circuit de polarisation arrière 106 relié électriquement à la matrice 102 et délivrant en sortie des tensions de polarisation arrière.

Des premiers éléments de couplage 108 couplent électriquement les points mémoires des cellules mémoires des colonnes 104 à des entrées du circuit de polarisation arrière 106. Des deuxièmes éléments de couplage 110 couplent électriquement des sorties du circuit de polarisation arrière 106 aux caissons de semi-conducteur dopé des cellules mémoires formant les bits de mémorisation de données.

Pour chaque ligne de la matrice 102, en fonction de la valeur binaire codée dans les bits de commande de polarisation arrière de cette ligne et lue par le circuit de polarisation arrière 106 grâce aux premiers éléments de couplage 108, le circuit de polarisation arrière 106 applique sur les caissons des transistors des cellules mémoires formant les bits de mémorisation de cette ligne de la matrice 102 une tension de polarisation dont la valeur dépend de celle codée dans les bits de commande de polarisation arrière de cette ligne de la matrice 102. Le circuit de polarisation arrière 106 établit donc une correspondance entre la valeur codée dans les bits de commande de polarisation arrière d'une ligne de la matrice 102 et la valeur de la tension de polarisation arrière appliquée sur les caissons de semi-conducteur dopé des transistors des cellules mémoires formant des bits de mémorisation de données de cette ligne de la matrice 102.

Ainsi, le dispositif mémoire 100 comporte une matrice 102 de cellules mémoires incluant des transistors dont la polarisation arrière peut être ajustée précisément et de manière indépendante pour chaque ligne de la matrice 102.

Sur l'exemple de réalisation représenté sur la figure 1, chaque ligne de la matrice 102 comporte deux bits de commande de polarisation arrière formés par les deux cellules mémoires des colonnes 104.1 et 104.2 se trouvant sur cette ligne. Ainsi, la valeur binaire codée dans les bits de commande de polarisation arrière peut prendre quatre valeurs différentes. Cette configuration permet donc d'appliquer, pour les transistors des cellules mémoires de chaque ligne de la matrice 102, une tension de polarisation arrière dont la valeur correspond à l'une parmi quatre valeurs possibles.

En variante, chaque ligne de la matrice 102 peut ne comporter qu'un seul bit de commande de polarisation arrière, la matrice 102 comportant dans ce cas une seule colonne 104. La valeur de la tension de polarisation arrière appliquée sur les transistors des cellules mémoires de chaque ligne de la matrice 102 est alors choisie parmi deux valeurs possibles, correspondant par exemple à la masse GND et à la tension d'alimentation VDD. De manière générale, chaque ligne de matrice 102 peut comporter *n* bits de commande de polarisation arrière (la matrice 102 comportant dans ce cas *n* colonnes 104), la valeur de la tension de polarisation appliquée sur les transistors des cellules mémoires de chacune des lignes de la matrice 102 pouvant être choisie parmi 2ⁿ valeurs possibles, avec n nombre entier supérieur ou égal à 1.

Les valeurs codées par les bits de commande de polarisation arrière peuvent varier d'une ligne à l'autre au sein de la matrice 102, ce qui permet d'avoir des valeurs des tensions de polarisation arrière appliquées qui sont indépendantes d'une ligne à l'autre des cellules mémoires de la matrice 102.

Selon un exemple de réalisation, le circuit de polarisation arrière 106 peut comporter un multiplexeur incluant des portes de transfert. Dans ce cas, les bits de commande de polarisation arrière peuvent commander les portes de transfert du multiplexeur du circuit de polarisation arrière 106 depuis lesquelles les tensions de polarisation arrière sont délivrées. Les tensions de polarisation arrière peuvent être générées au sein du circuit de polarisation arrière 106, ou bien être obtenues depuis l'extérieur du circuit de polarisation arrière 106, avec dans ce cas le circuit de polarisation arrière 106 assurant la sélection de la valeur de la tension de polarisation arrière à appliquer pour chacune des lignes de cellules mémoires de la matrice 102.

Sur l'exemple de réalisation représenté sur la figure 1, les cellules mémoires formant les bits de commande de polarisation arrière correspondent aux cellules mémoires de colonnes formant le bord droit de la matrice 102. En variante, les cellules mémoires formant les bits de commande de polarisation arrière peuvent correspondre aux cellules mémoires d'une ou plusieurs colonnes différentes de celles représentées sur la figure 1, par exemple celles formant le bord gauche de la matrice 102.

Le dispositif mémoire 100 comporte également un circuit d'attaque de lignes de mot 112 relié électriquement aux lignes de mot du dispositif 100 (non visibles sur la figure 1) et qui commande l'accès en lecture ou en écriture dans chacune des lignes de la matrice 102 (aux cellules mémoires formant les bits de mémorisation de données et aux cellules mémoires formant les bits de commande de polarisation arrière).

Dans le dispositif 100 précédemment décrit, si toute la matrice 102 est alimentée entre un potentiel d'alimentation V_{DD} et un potentiel de référence GND, les valeurs mémorisées dans chacun des bits des colonnes 104 correspondent, de manière statique, à l'une des deux valeurs des potentiels V_{DD} ou GND, par exemple V_{DD} qui correspond à l'état haut et GND qui correspond à l'état bas. Cependant, selon un autre exemple de réalisation, il est possible que les potentiels électriques utilisés pour alimenter électriquement les cellules mémoires des colonnes 104 soient différents de ceux alimentant les cellules mémoires formant les bits de mémorisation de données. Par exemple, les cellules mémoires de la colonne 104.1 peuvent être alimentées entre des potentiels électriques V_{DD1} et GND1 et les cellules mémoires de la colonne 104.2 peuvent être alimentées entre des potentiels électriques V_{DD2} et GND2, ces valeurs pouvant être différentes les unes des autres et différentes de celles de V_{DD} et GND alimentant les cellules mémoires formant les bits de mémorisation de données. Les valeurs de ces potentiels électriques sont toutefois choisies telles que la stabilité de fonctionnement des cellules mémoires des colonnes 104 ne soit pas compromise.

Le dispositif mémoire 100 est réalisé sous la forme d'un circuit 3D comportant au moins deux couches actives de semi-conducteur superposées et entre lesquelles plusieurs couches métalliques d'interconnexions sont empilées.

La figure 2 représente schématiquement une vue en coupe d'une partie du dispositif 100 comprenant deux niveaux 114, 116 superposés et solidarisés l'un à l'autre sous la forme d'un circuit 3D.

Le premier niveau 114 est réalisé à partir d'un premier substrat SOI comprenant une première couche support 118 comportant par exemple de silicium, une première couche diélectrique enterrée 120 comportant par exemple du SiO₂ et une première couche active 122 de semi-conducteur, par exemple du silicium. Des composants électroniques, notamment des transistors FET de type FDSOI, sont réalisés dans la première couche active 122 et forment différents circuits du dispositif mémoire 100 : décodeur de lignes, amplificateurs de lecture, etc. Plusieurs couches métalliques d'interconnexions 124 sont réalisées au-dessus de la première couche active 122 et forment notamment des liaisons électriques reliées aux composants électroniques réalisés dans la première couche active 122.

Le deuxième niveau 116 est réalisé à partir d'un deuxième substrat SOI comprenant une deuxième couche support 126 comportant par exemple du silicium, une deuxième couche diélectrique enterrée 128 comportant par exemple du SiO₂ et une deuxième couche active 130 de semi-conducteur, par exemple du silicium. Des composants électroniques, notamment des transistors FET de type FDSOI, sont réalisés dans la deuxième couche active 130. Ces autres composants électroniques forment notamment la matrice 102 de cellules mémoires, le circuit de polarisation arrière 106 et le circuit d'attaque de lignes de mot 112. Plusieurs couches métalliques d'interconnexions 131 sont réalisées au-dessus de la deuxième couche active 130 et assurent notamment les liaisons électriques reliées aux composants électroniques réalisés dans la deuxième couche active 130.

Des détails de réalisation d'un tel circuit 3D sont décrits dans le document « Design Technology Co-Optimization of 3D-monolithic standard cells and SRAM exploiting dynamic back-bias for ultra-low-voltage opération » de F. Andrieu et al., 2017 IEEE International Electron Devices Meeting (IEDM). Des caissons de semi-conducteur dopé formant des plans de masse des transistors des cellules mémoires sont réalisés dans la deuxième couche support 126 et sont désignés, sur la figure 2, par la référence 132. Des vias électriquement conducteurs 134 assurent les liaisons électriques entre les deux niveaux 114 et 116. Etant donné la densité avec laquelle les cellules mémoires 102 sont réalisées dans la deuxième couche active 130, les couches métalliques d'interconnexions 131 du niveau 116 dans lequel est réalisée la matrice 102 de cellules mémoires n'offrent pas un espace suffisant pour réaliser les premiers et deuxièmes éléments de couplage 108, 110. Les couches métalliques d'interconnexions d'un autre niveau du circuit, ici les couches 124 du niveau inférieur 114, sont utilisées pour réaliser ces éléments de couplage 108, 110.

Dans l'exemple de réalisation décrit ici, les premiers éléments de couplage 108 comportent des portions de l'une des couches métalliques d'interconnexions 124 du niveau inférieur 114 qui correspond à celle qui est la plus proche du niveau supérieur 116 et qui est appelée dernière couche métallique d'interconnexions (et qui porte la référence 133 sur la figure 2), et les deuxièmes éléments de couplage 110 comporte des portions d'une autre des couches métalliques d'interconnexions 124 du niveau inférieur 114 qui se trouve entre la dernière couche métallique d'interconnexions 133 et les autres couches métalliques d'interconnexions 124 et qui est appelée avant-dernière couche métallique d'interconnexions (et qui porte la référence 135 sur la figure 2). Par exemple, si le niveau inférieur 114 comporte six couches métalliques d'interconnexions 124 superposées, la première couche métallique d'interconnexions étant celle qui est la plus proche de la première couche active 122 et la sixième, ou dernière, couche métallique d'interconnexions étant celle qui est la plus éloignée de la première couche active 122, les premiers éléments de couplage 108 sont réalisés dans la sixième, ou dernière, couche métallique d'interconnexions et les deuxièmes éléments de couplage 110 sont réalisés dans la cinquième, ou avant-dernière, couche métallique d'interconnexions.

En variante, il est possible que les composants électroniques réalisés, dans l'exemple ci-dessus, dans la première couche active 122 et formant différents circuits du dispositif mémoire 100 (décodeur de lignes, amplificateurs de lecture, etc.) soient réalisés dans la deuxième couche active 130, avec les autres éléments formant le dispositif mémoire 100.

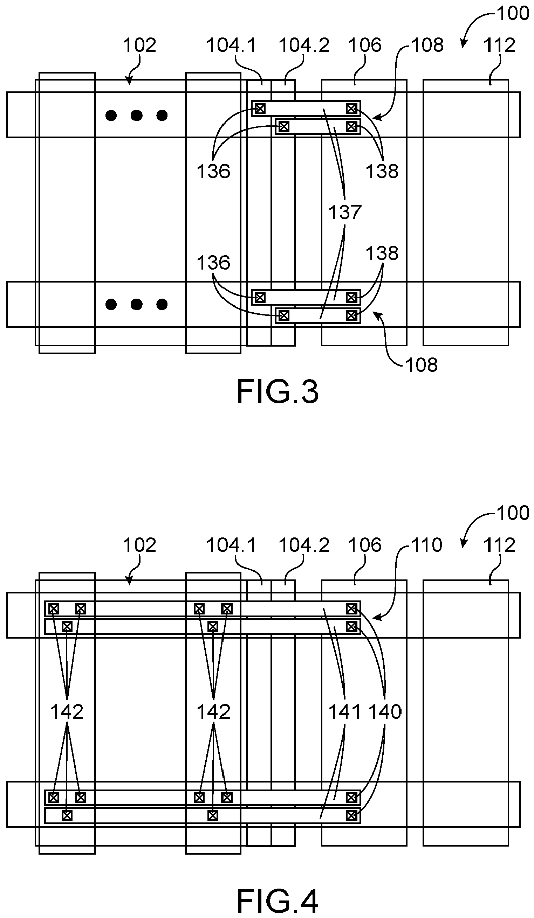

La figure 3 est une vue du dispositif 100 sur laquelle les premiers éléments de couplage 108 reliant les points mémoires des cellules mémoires des colonnes 104 (c'est-à-dire les cellules formant les bits de commande de polarisation arrière) de deux lignes de la matrice 102 au circuit de polarisation arrière 106 sont visibles. Ces premiers éléments de couplage 108 comportent des portions métalliques 137 de l'une des couches métalliques d'interconnexions 124, par exemple la dernière couche métallique d'interconnexions 133, des vias conducteurs 136 reliant les points mémoires de ces cellules mémoires 102 à ces portions métalliques 137, et des vias conducteurs 138 reliant ces portions métalliques 137 à des entrées du circuit de polarisation arrière 106. Sur l'exemple de réalisation représenté sur la figure 3, étant donné que les bits de commande de polarisation arrière sont formés par les cellules de deux colonnes 104.1 et 104.2, deux premiers éléments de couplage 108 sont utilisés pour chaque ligne de la matrice 102, chacun de ces premiers éléments de couplage 108 étant relié à l'une des cellules mémoires de ces deux colonnes 104.1 et 104.2.

La figure 4 est une vue du dispositif 100 sur laquelle les deuxièmes éléments de couplage 110 reliant le circuit de polarisation arrière 106 aux caissons de semi-conducteur dopé des transistors des cellules mémoires de la matrice 102 formant les bits de mémorisation de données, pour deux lignes de la matrice 102, sont visibles. Ces deuxièmes éléments de couplage 110 comportent des portions métalliques 141 de l'une des couches métalliques d'interconnexions 124, par exemple l'avant-dernière couche métallique d'interconnexions, des vias conducteurs 140 reliant des sorties du circuit de polarisation arrière 106 (sur lesquels les tensions de polarisation arrière sont délivrées) aux portions métalliques 141, et des vias conducteurs 142 reliant les portions métalliques 141 aux caissons de semi-conducteur dopé des transistors des cellules formant les bits de mémorisation de données de la ligne associée. Sur l'exemple de la figure 4, les transistors de chacune des cellules mémoires comportent ensemble trois caissons, l'un étant dopé P et disposé sous les zones actives des transistors PMOS et les deux autres étant dopés N et disposés sous les zones actives des transistors NMOS. Etant donné que les tensions de polarisation arrière appliquées sur les caissons de semi-conducteur dopé N sont différentes de celles appliquées sur le caisson de semi-conducteur dopé P, deux deuxièmes éléments de couplage 110 sont utilisés pour chaque ligne de la matrice 102, l'une assurant la liaison entre le circuit de polarisation arrière 106 et les caissons de semi-conducteur dopé N et l'autre assurant la liaison entre le circuit de polarisation arrière 106 et le caisson de semi-conducteur dopé P.

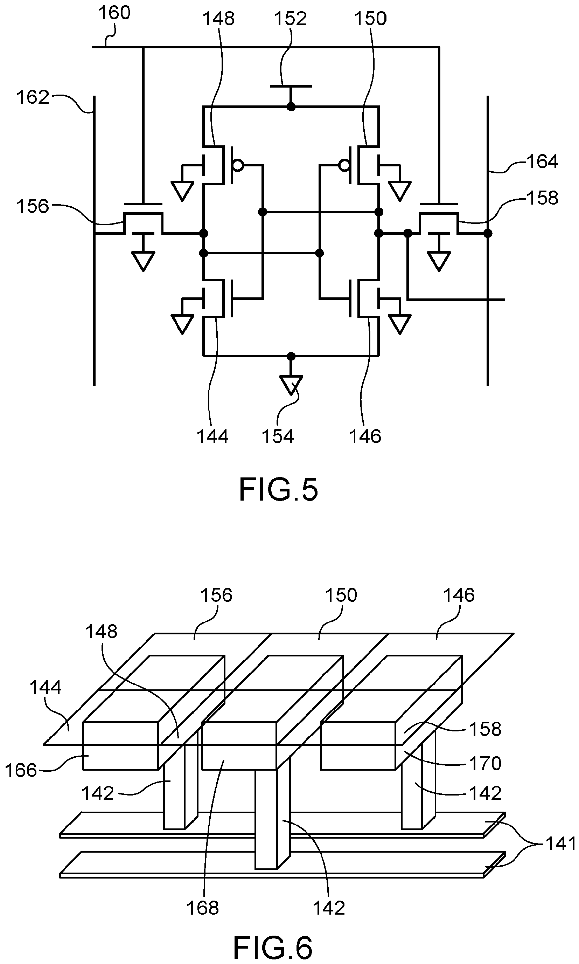

La figure 5 représente un exemple de réalisation d'une cellule mémoire de type 6T-SRAM dont les zones actives des transistors sont formées au-dessus de trois caissons de semi-conducteur dopé comme sur l'exemple de la figure 4, c'est-à-dire avec un caisson de semi-conducteur dopé P et deux caissons de semi-conducteur dopé N.

Sur la figure 5, la cellule mémoire comporte deux transistors NMOS 144, 146, appelés transistors « pull-down », et deux transistors PMOS 148, 150, appelés transistors « pull-up », formant ensemble deux inverseurs montés tête-bêche et qui définissent le point mémoire de la cellule. Ces deux inverseurs sont reliés à une borne d'alimentation électrique 152 sur laquelle est appliqué un potentiel d'alimentation V_{DD}, par exemple égal à environ 1 V, et à un potentiel de référence 154 GND correspondant par exemple à la masse du dispositif mémoire 100. La cellule mémoire comporte également deux transistors d'accès 156, 158, également appelés transistors « pass-gate », ici de type NMOS, comportant leur grille reliée à une ligne de mot 160 sur laquelle un signal commandant une lecture ou une écriture dans la cellule mémoire est destiné à transiter. Les drains des transistors d'accès 156, 158 sont reliés à des lignes de bit 162, 164 sur lesquelles transitent les données à mémoriser ou à écrire, et leur source reliée aux inverseurs formés par les transistors 144, 146, 148 et 150.

La figure 6 représente schématiquement une configuration des caissons de semi-conducteur dopé permettant une polarisation arrière des transistors de la cellule mémoire précédemment décrite en lien avec la figure 5.

Sur la figure 6, les emplacements des transistors de la cellule mémoire sont représentés symboliquement par des rectangles portant les mêmes références que les transistors décrits précédemment en lien avec la figure 5. Un premier caisson de semi-conducteur dopé N 166 permet la polarisation arrière des transistors 144 et 156 qui sont tous les deux de type N. Un deuxième caisson de semi-conducteur dopé P 168 permet la polarisation arrière des transistors 148 et 150 qui sont tous les deux de type P. Un troisième caisson de semi-conducteur dopé N 170 permet la polarisation arrière des transistors 146 et 158 qui sont tous les deux de type N. Les deux caissons de semi-conducteur dopé N 166 et 170 sont reliés à l'une des portions métalliques 141 et le caisson de semi-conducteur dopé P 168 est relié à l'autre des portions métalliques 141. Les connexions électriques entre les caissons 166, 168, 170 et les portions 141 sont réalisées par les vias conducteurs 142.

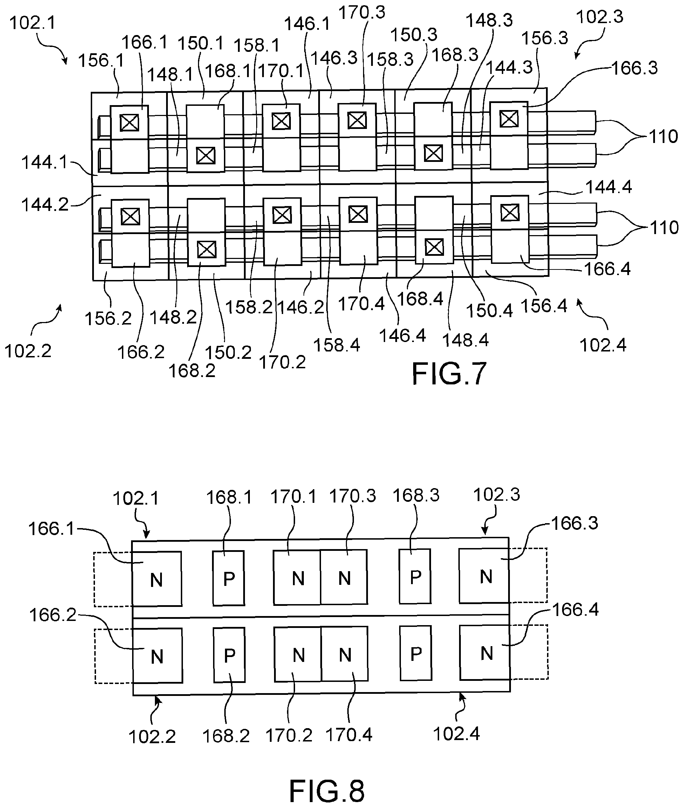

Selon un exemple de réalisation avantageux, les cellules mémoires formant les bits de mémorisation de données peuvent être agencées en formant des groupes de quatre cellules mémoires juxtaposées et réparties sur deux lignes et deux colonnes de la matrice telles que les transistors des deux cellules se trouvant sur la première des deux lignes soient agencés de manière symétrique par rapport aux transistors des deux cellules se trouvant sur la deuxième des deux lignes, et que les transistors des deux cellules se trouvant sur la première des deux colonnes soient agencés de manière symétrique par rapport aux transistors des deux cellules se trouvant sur la deuxième des deux colonnes. La figure 7 représente schématiquement un tel agencement des transistors de quatre cellules mémoires 102.1 à 102.4, ainsi que la répartition des caissons de semi-conducteur dopé permettant la polarisation arrière de ces transistors. Sur la figure 7, les mêmes références que celles indiquées sur la figure 6 sont utilisées, avec l'ajout du nombre .1, .2, .3 ou .4 selon la cellule mémoire à laquelle appartient l'élément référencé.

Dans le dispositif mémoire 100 tel que décrit précédemment, la polarisation arrière des transistors des cellules mémoires de la matrice 102 formant les bits de mémorisation de données est indépendante pour chacune des lignes de cellules mémoires. Pour cela, les caissons de semi-conducteur dopés par l'intermédiaire desquels la polarisation arrière est réalisée pour les transistors de cellules mémoires disposées sur deux lignes adjacentes ne se touchent pas et ne sont pas reliés électriquement l'un à l'autre. Par contre, il est possible que des caissons appartenant à deux colonnes adjacentes, comprenant un semi-conducteur dopé selon le même type de dopage et qui sont disposés l'un à côté de l'autre, soient formés par une même portion de semi-conducteur dopé. La figure 8 représente schématiquement une telle configuration dans laquelle chacun des caissons 166 et 170 de semi-conducteur dopé N d'une première cellule mémoire est formé par une portion de semi-conducteur commune à un autre caisson 166 ou 170 de semi-conducteur dopé N d'une deuxième cellule mémoire adjacente à la première cellule mémoire.

En variante, il est possible que les caissons de semi-conducteur dopé selon un même type de conductivité (caissons 166 et 170 dans l'exemple précédent) soient reliés à des portions métalliques 110 différentes, chaque paire de transistors de même type étant associé à une de ces portions métalliques 110.

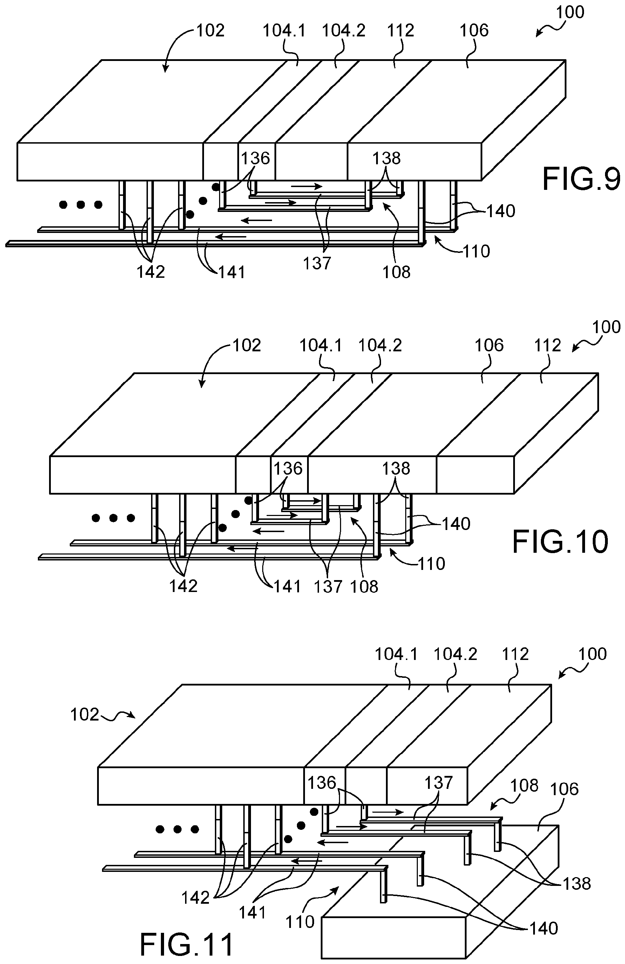

Les figures 9 et 10 représentent schématiquement des exemples de réalisation du dispositif mémoire 100 dans lesquels la matrice 102 de cellules mémoires et les circuits 106 et 112 sont réalisés dans une même couche active (par exemple la couche active 130 représentée sur la figure 2), avec les premiers et deuxièmes éléments de couplage 108, 110 comprenant des portions métalliques 137, 141 formées à partir d'une même couche métallique d'interconnexions. La différence entre ces deux exemples de réalisation représentés sur les figures 9 et 10 porte sur la position des circuits 106 et 112 l'un par rapport à l'autre : sur la figure 9, le circuit d'attaque de lignes de mot 112 est disposé entre la matrice 102 de cellules mémoires et le circuit de polarisation arrière 106, et sur la figure 10, le circuit de polarisation arrière 106 est disposé entre la matrice 102 de cellules mémoires et le circuit d'attaque de lignes de mot 112.

La figure 11 représente un autre exemple de réalisation du dispositif mémoire 100 dans lequel le circuit de polarisation arrière 106 est formé dans une autre couche active (par exemple la couche active 122 représentée sur la figure 2) disposée sous celle (par exemple la couche active 130 représentée sur la figure 2) dans laquelle sont réalisés la matrice 102 de cellules mémoires et le circuit d'attaque de lignes de mot 112.

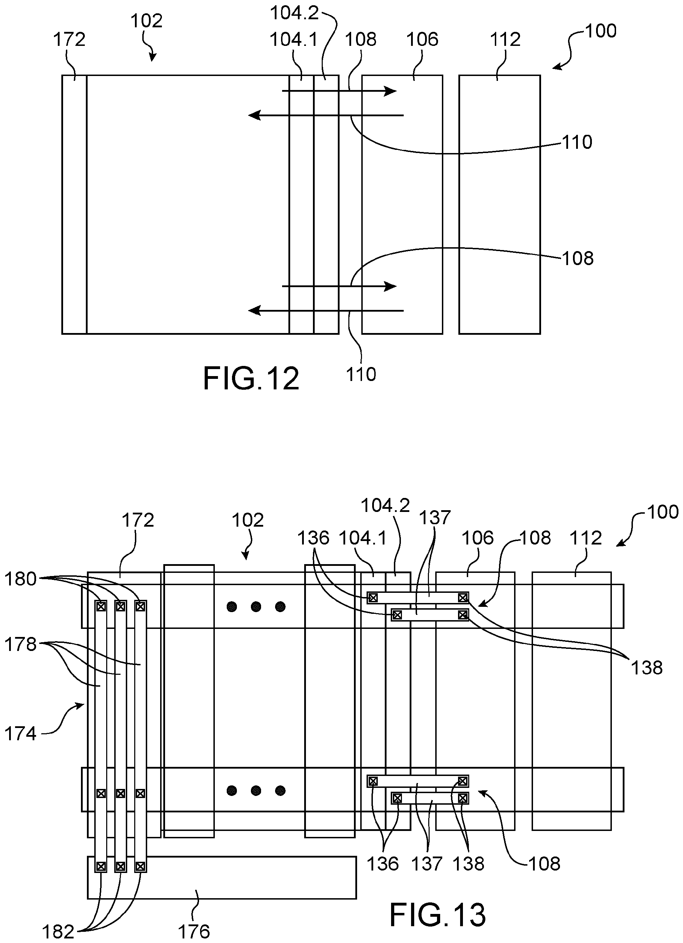

La figure 12 représente schématiquement le dispositif mémoire 100 selon un deuxième mode de réalisation.

Comme dans le premier mode de réalisation, le dispositif mémoire 100 comporte la matrice 102 de cellules mémoires de type SRAM dans laquelle les cellules mémoires d'une ou plusieurs colonnes 104 forment des bits de commande de polarisation arrière servant à mémoriser des états de polarisation arrière des autres cellules mémoires de la matrice 102 formant des bits de mémorisation de données.

Dans ce deuxième mode de réalisation, les cellules mémoires d'au moins une colonne 172 correspondent à des bits de commande de fin de lecture. Sur l'exemple de réalisation représenté sur la figure 12, la colonne 172 forme le bord gauche de la matrice 102, tandis que les colonnes 104 forment le bord droit de la matrice 102. De manière générale, la colonne 172 dont les cellules mémoires forment les bits de commande de fin de lecture est choisie telle que cette colonne 172 soit celle qui est la plus éloignée du décodeur de ligne associé à la matrice 102 et qui se trouve ici du côté des colonnes 104.

Les caissons de semi-conducteur dopé du même type des transistors des cellules mémoires de la colonne 172 sont couplés électriquement entre eux par des troisièmes éléments de couplage, non visibles sur la figure 12. Ces troisièmes éléments de couplage comportent notamment des portions de l'une des couches métalliques d'interconnexions, avantageusement de la dernière couche métallique d'interconnexion électrique 133 (celle la plus proche de la couche active dans laquelle la matrice 102 est réalisée), qui s'étendent verticalement afin de relier tous les caissons de semi-conducteur dopé du même type de conductivité présents sur la colonne 172 (contrairement aux caissons de semi-conducteur dopé des autres cellules mémoires de la matrice 102 qui sont couplés par ligne). C'est notamment en raison de cela que la colonne 172 est choisie comme étant celle qui est la plus éloignée du décodeur de ligne associé à la matrice 102 et qui se trouve du côté des colonnes 104.

Les cellules mémoires de la colonne 172 sont couplées à un circuit du dispositif 100, non visible sur la figure 12, qui commande une fin de lecture des bits de mémorisation de données. En effet, ces cellules mémoires de la colonne 172 permettent de réaliser une détection de l'instant optimal auquel une lecture doit être achevée, c'est-à-dire le moment auquel la décharge du courant dans l'une des lignes de bit est suffisante pour permettre une lecture sans erreur de données stockées dans les bits de mémorisation de données. En fonction du nombre de cellules mémoires de la colonne 172 activés simultanément, une décharge complète des lignes de bits de ces cellules permet de définir une fin de lecture pour les cellules mémoires formant les bits de mémorisation de données. Les cellules mémoires de la colonne 172 comportent des transistors d'accès dont les grilles sont couplées à une même ligne de mot distincte de celles auxquelles les grilles des transistors d'accès des cellules mémoires formant les bits de mémorisation de données sont couplées.

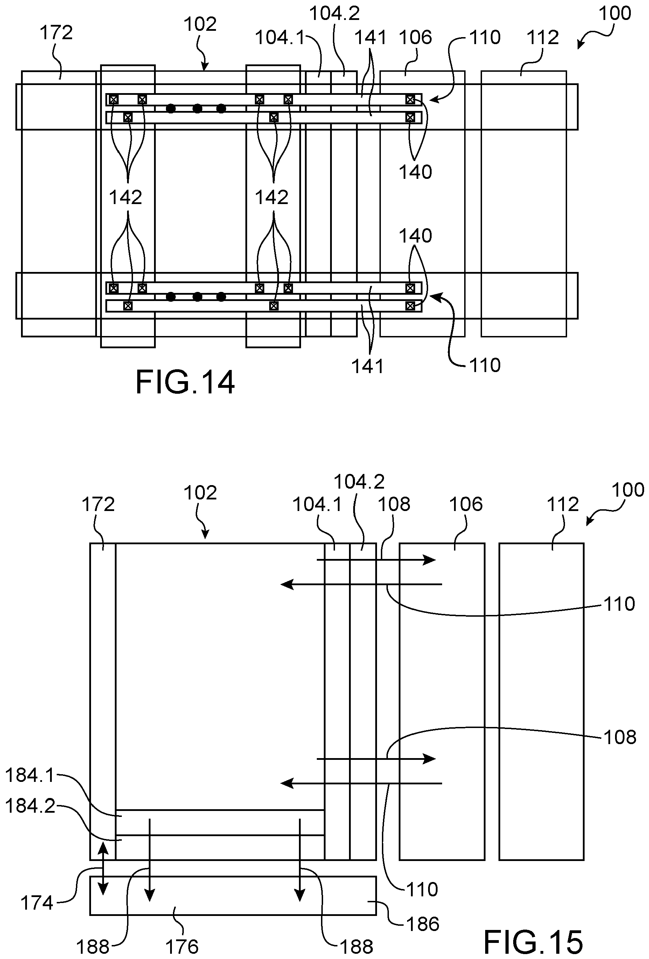

Les figures 13 et 14 représentent un exemple de réalisation des éléments de couplage du dispositif mémoire 100 selon ce deuxième mode de réalisation.

La figure 13 représente différents éléments de couplage du dispositif mémoire 100 selon le deuxième mode de réalisation qui sont réalisés dans la dernière couche métallique d'interconnexions, ici les premiers éléments de couplage 108 et des troisièmes éléments de couplage 174. Les premiers éléments de couplage 108 sont ici similaires à ceux précédemment décrits en lien avec la figure 3. Dans ce deuxième mode de réalisation, les troisièmes éléments de couplage 174 relient les caissons de semi-conducteur dopé des cellules mémoires de la colonne 172 à un autre circuit de polarisation arrière 176 appliquant les tensions de polarisation arrière souhaitées pour les cellules de la colonne 172. Les troisièmes éléments de couplage 174 comportent des portions métalliques 178 de la dernière couche métallique d'interconnexions ainsi que des vias électriquement conducteurs 180 reliant les portions métalliques 178 aux caissons de semi-conducteur dopé des cellules mémoires de la colonne 172 et des vias électriquement conducteurs 182 reliant les portions métalliques 178 au circuit de polarisation arrière 176.

La figure 14 représente les éléments de couplage du dispositif 100 selon le deuxième mode de réalisation, réalisés dans l'avant dernière couche métallique d'interconnexions, c'est-à-dire ici les deuxièmes éléments de couplage 110. Les deuxièmes éléments de couplage 110 sont ici similaires à ceux précédemment décrits en lien avec la figure 4.

Selon une variante de réalisation du deuxième mode de réalisation décrit ci-dessus, il est possible que les troisièmes éléments de couplage 174 soient réalisés dans la même couche métallique d'interconnexions que celle dans laquelle sont réalisés les deuxièmes éléments de couplage 110, par exemple l'avant dernière couche d'interconnexions métalliques.

La figure 15 représente un dispositif mémoire 100 selon un troisième mode de réalisation.

Dans ce troisième mode de réalisation, la matrice 102 comporte tous les éléments précédemment décrits en lien avec le deuxième mode de réalisation, notamment les colonnes 104 et 172. En outre, une ou plusieurs lignes 184 de cellules mémoires de la matrice 102 forment des deuxièmes bits de commande de polarisation arrière dans lesquels sont mémorisés des états de polarisation arrière de transistors d'un bloc d'entrées / sorties 186 du dispositif 100 auquel les colonnes de la matrice 102 sont reliées. Sur l'exemple de la figure 15, les cellules mémoires de deux lignes 184.1 et 184.2, qui forment le bord inférieur de la matrice 102, correspondent à ces deuxièmes bits de commande de polarisation arrière.

Des quatrièmes éléments de couplage 188 couplent électriquement les points mémoires des cellules mémoires des lignes 184 à un deuxième circuit de polarisation arrière, par exemple inclus dans le bloc d'entrées/sorties 186, et configuré pour délivrer en sortie des tensions de polarisation arrière dont les valeurs dépendent de celles stockées dans les deuxièmes bits de commande de polarisation arrière. Le deuxième circuit de polarisation arrière est couplé à des caissons de semi-conducteur dopé de transistors FET faisant partie du bloc 186. Ces transistors correspondent par exemple à ceux d'un ou plusieurs des circuits auxquels les colonnes de cellules mémoires de la matrice 102 sont reliées, soit indépendamment l'une de l'autre soit de manière groupée: circuit de pré-charge des lignes de bit de la matrice 102, circuits multiplexeurs, amplificateurs de détection, circuit d'aide à l'écriture/lecture, ou tout autre circuit faisant partie du bloc 186.

Dans ce troisième mode de réalisation, la polarisation arrière des transistors du bloc d'entrées/sorties 186 peut être précisément ajustée, ce qui permet par exemple d'accélérer ou ralentir les opérations de lecture ou d'écriture indépendamment pour chaque colonne de la matrice 102.

Sur la figure 15, le bloc d'entrées/sorties 186 et le circuit de polarisation arrière 176 qui est couplé aux cellules mémoires de la colonne 172 sont représentés sous la forme d'un seul élément.

Selon un exemple de réalisation de ce troisième mode de réalisation, lorsque le dispositif mémoire 100 est dans une configuration mémoire de type MUX4 (chaque entrée/sortie du bloc 186 est couplée à quatre colonnes de cellules mémoires de la matrice 102 par l'intermédiaire d'un multiplexeur, comme c'est le cas par exemple pour une matrice 102 comprenant 128 colonnes et mémorisant dans chaque ligne des mot de 32 bits) et que la matrice 102 comporte deux lignes 184, une de ces deux lignes 184 peut servir à mémoriser les états de polarisation pour accélérer ou non les transistors d'un ou plusieurs circuits reliés à une des quatre colonnes, et la deuxièmes ligne 184 peut servir à mémoriser sur quatre bits (du fait que chaque entrée/sortie du bloc 106 est couplée à quatre colonnes) des états de polarisation arrière de transistors d'un ou plusieurs circuits partagés par les quatre colonnes associées ou utiliser une bit différent pour chacun de ces circuits : par exemple un bit dédié à la polarisation arrière des transistors de l'amplificateur de détection, un bit dédié au bloc d'assistance d'écriture, ou « write assist », un bit dédié au bloc de mémorisation de données, et un dernier bit pour le circuit tampon. Ces quatre bits peuvent également servir à sélectionner une tension de polarisation arrière commune à tous ces circuits parmi plusieurs tensions de polarisation de différentes valeurs générées par un circuit de génération de tensions de polarisation. Selon un autre exemple, étant donné que la polarisation arrière des NMOS est différente de celles des PMOS, il est possible d'avoir quatre bits utilisés pour accélérer ou ralentir le circuit de pré-charge associé à chacune des colonnes, un autre bit utilisé de manière globale pour les transistors NMOS des dispositifs multiplexeurs, un autre bit utilisé de manière globale pour les transistors PMOS des dispositifs multiplexeurs, un autre bit pour les transistors NMOS des amplificateurs de détection, et un dernier bit pour les transistors PMOS des amplificateurs de détection.

Le paragraphe ci-dessus s'applique également pour un nombre de colonnes partagées différent de 4.

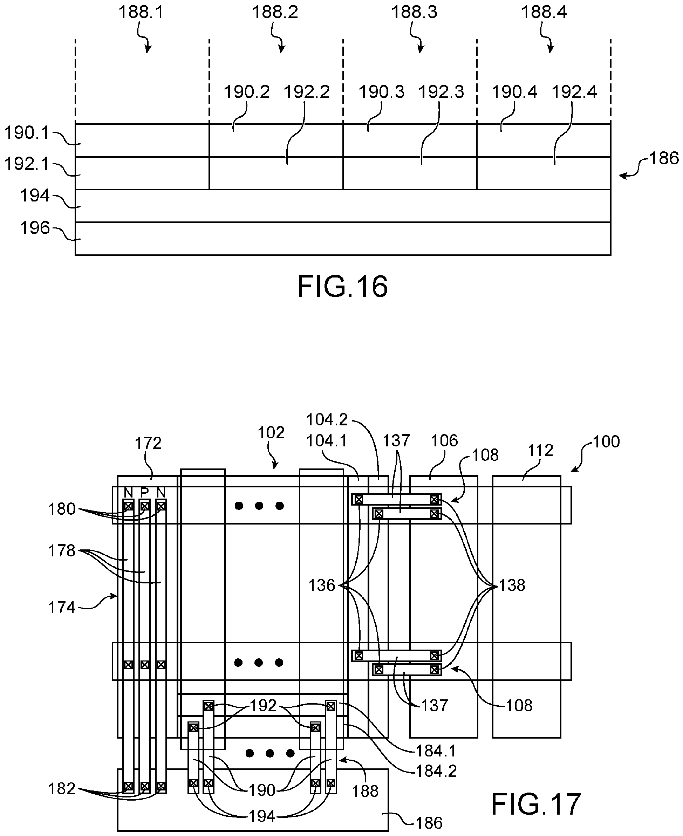

La figure 16 représente schématiquement cette configuration dans laquelle quatre colonnes 188.1, 188.2, 188.3 et 188.4 de cellules mémoires de la matrice 102 formant des bits de mémorisation de données sont reliées au bloc d'entrées/sorties 186. Chacune des colonnes 188.1 - 188.4 est couplée à un circuit de pré-charge 190 (190.1 à 190.4 sur la figure 16) et à un circuit multiplexeur de lecture/écriture 192 (192.1 à 192.4 sur la figure 16). Enfin, les quatre colonnes 188.1 - 188.4 de cellules mémoires de la matrice 102 sont reliées à un amplificateur de détection 194 et à un circuit d'aide à l'écriture/lecture 196 communs à ces quatre colonnes 188.1 - 188.4.

La figure 17 représente un exemple de réalisation des éléments de couplage formés dans l'une des couches métalliques d'interconnexions du dispositif mémoire selon le troisième mode de réalisation. Dans cet exemple de réalisation, les quatrièmes éléments de couplage 188 sont réalisés dans la même couche métallique d'interconnexions, avantageusement la dernière couche métallique d'interconnexions, que celle dans laquelle sont réalisés les premiers et troisièmes éléments de couplage 108, 174. Les quatrièmes éléments de couplage 188 comportent des portions 190 de cette couche métallique d'interconnexions, des vias électriquement conducteurs 192 couplant électriquement les points mémoires des transistors des cellules des lignes 184 aux portions 190, et des vias électriquement conducteurs 194 couplant électriquement les portions 190 au deuxième circuit de polarisation arrière ici inclus dans le bloc 186. Les deuxièmes éléments de couplage 110, non visible sur la figure 17, comportent des portions métalliques d'une autre couche métallique d'interconnexions, par exemple l'avant-dernière couche métallique d'interconnexions.

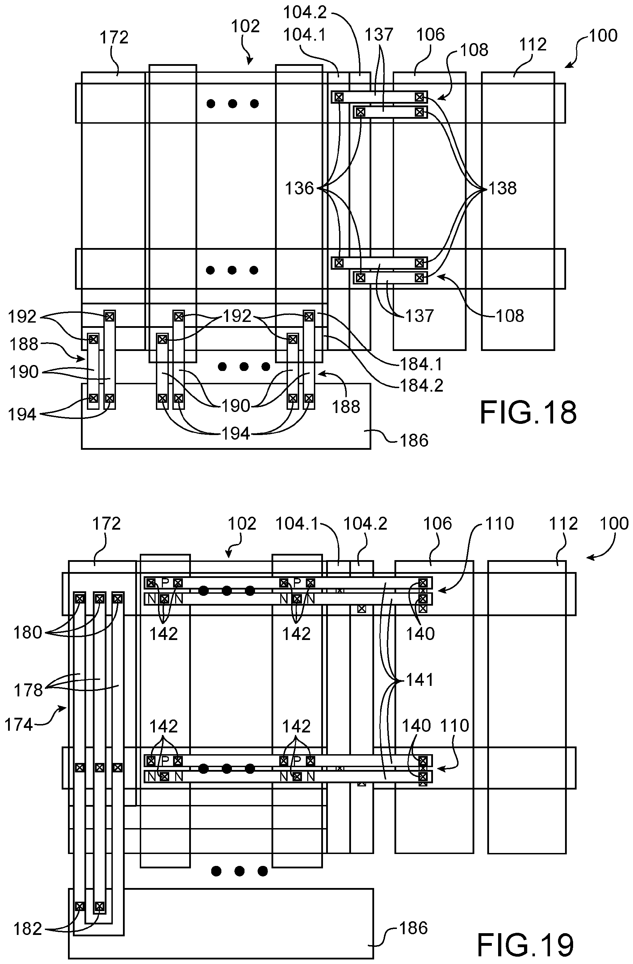

Les figures 18 et 19 représentent une variante du troisième mode de réalisation. Dans cette variante, les lignes 184 servent également à stocker les états de polarisation arrière des transistors de la colonne 172. La figure 18 représente les éléments de couplage réalisés dans la dernière couche métallique d'interconnexions, et la figure 19 représente les éléments de couplage réalisés dans l'avant-dernière couche métallique d'interconnexions.

Dans les exemples de réalisation des trois modes de réalisation précédemment décrits, chaque cellule mémoire comporte des caissons dopés selon les deux types de conductivité N et P. Ainsi, pour chaque ligne de cellules mémoires de la matrice 102, deux portions métalliques sont utilisées pour réaliser les connexions aux caissons de polarisation arrière des transistors de chaque cellule mémoire. En variante, si chaque cellule mémoire comporte des transistors comprenant un ou plusieurs caissons de semi-conducteur dopé selon un seul type de conductivité N ou P, une seule portion métallique 141 peut être réalisée pour former l'élément de couplage associé à chaque ligne de cellules mémoires.

En outre, si un seul bit de commande de polarisation est utilisé pour chaque ligne de la matrice 102 pour déterminer la valeur de la tension de polarisation à appliquer sur les caissons de cette ligne, chacun des premiers éléments de couplage 108 associé à une ligne de la matrice 102 peut comporter une seul portion métallique 137.

Suivant le nombre de portions métalliques utilisées et l'espace disponible au sein des couches métalliques d'interconnexions, une seule couche métallique d'interconnexions peut servir à former les portions métalliques des premier et deuxième éléments de couplage 108, 110, comme c'est le cas dans les exemples de réalisation précédemment décrits en lien avec les figures 9 et 10. Par exemple, si la surface disponible pour chaque ligne de cellules mémoires permet d'avoir deux portions métalliques pour chaque ligne, et si un seul bit de commande de polarisation est utilisé pour chaque ligne de cellules mémoires et qu'un seul type de caisson de polarisation arrière est utilisé pour chaque cellule mémoire, les premiers et deuxièmes éléments de couplage peuvent comporter des portions métalliques issues de la même couche métallique d'interconnexions, avantageusement la dernière couche métallique d'interconnexions.

Selon une autre variante, il est possible d'utiliser plus de deux couches métalliques d'interconnexions pour former les différentes portions métalliques faisant partie des différents éléments de couplage du dispositif 100.

Dans tous les modes de réalisation précédemment décrits, les premiers et deuxièmes éléments de couplage comportent des portions de couches métalliques d'interconnexions disposées entre les deux couches actives 122, 130. En variante, il est possible que seuls les premiers éléments de couplage ou seuls les deuxièmes éléments de couplage comportent des portions d'au moins une couche métallique d'interconnexions disposée entre les deux couches actives 122, 130, et que les autres éléments de couplage comportent des portions d'une des couches métalliques d'interconnexions 131 disposées au-dessus de la couche active 130.

De manière générale, les cellules mémoires des colonnes 104 et éventuellement de la colonne 172 occupent une surface qui est la plus faible possible, et ont de préférence des transistors similaires à ceux des autres cellules mémoires formant les bits de mémorisation de données de la matrice 102. Ces transistors sont de préférence agencés de manière similaire aux transistors des autres cellules mémoires.

De plus, l'agencement des transistors des cellules mémoires des colonnes 104 est tel que les vias électriquement conducteurs 136, qui sont reliés aux points mémoires de ces cellules, sont reliés à ces points mémoires par l'intermédiaire des portions de polysilicium formant les grilles des transistors qui sont reliées à ces points mémoires. Ainsi, aucune surface n'est perdue à cause des connexions des vias électriquement conducteurs des éléments de couplage aux points mémoires des cellules mémoires, la surface occupée par les cellules mémoires des colonnes 104 pouvant être similaire à celle des autres cellules mémoires de la matrice 102.

Quel que soit le mode de réalisation considéré, la polarisation arrière des cellules mémoires réalisée au sein du dispositif mémoire 100 permet de réalisation des détections d'erreur et une autocorrection de ces erreurs. Par exemple, pour une erreur de lecture et/ou d'écriture détectée sur un mot ou une colonne, une amélioration ou une dégradation des performances de la ou des cellules mémoires dans lesquelles l'erreur se produit peut être réalisée en modifiant la polarisation arrière des transistors de ces cellules mémoires. De la même manière, si une colonne de cellules mémoires est dédiée à une détection de fin de lecture, la durée de lecture des cellules mémoires peut être ajustée.

Dans tous les modes de réalisation et exemples précédemment, le principe d'ajuster la polarisation arrière d'un ou plusieurs transistors FET peut s'appliquer pour des cellules mémoires qui peuvent être de type SRAM, ou CAM, ou TCAM, voire mêmes DRAM ou ROM lorsque ces cellules mémoires comportent au moins un transistor FET.

Dans les dispositifs 100 précédemment décrits, le circuit 3D formant le dispositif mémoire 100 est tel que la première couche active 122 fait partie d'un substrat comportant la couche support 118, la première couche active 122 étant disposée entre la couche support 118 et la deuxième couche active 130.

Dans les dispositifs 100 précédemment décrits, les éléments de couplage 108, 110 comportent des portions métalliques 137, 141 d'au moins une des couches métalliques d'interconnexions 133, 135 faisant partie du BEOL (« Back-End Of Line »), ou structure de métallisation finale, du premier niveau 114, réalisées sur la première couche active 122.

Dans les modes de réalisation et variantes du dispositif mémoire 100 précédemment décrits, les éléments électriquement conducteurs de polarisation arrière 166, 168, 170 des transistors 144, 146, 148, 150, 156, 158 des cellules mémoires formant les bits de mémorisation de données sont disposés entre les portions métalliques 137, 141 des éléments de couplage 108, 110 et la deuxième couche active 130. Dans l'exemple de réalisation de la figure 2, la couche support 126 du substrat incluant la deuxième couche active 130 est disposée entre la deuxième couche active 130 et la première couche active 122. En variante, il est possible que la deuxième couche active 130 soit disposée entre les éléments électriquement conducteurs de polarisation arrière 166, 168, 170 et les portions métalliques 137, 141 des éléments de couplage 108, 110, ou que la deuxième couche active 130 soit disposée entre la couche support 126 et la première couche active 122. Une telle variante peut être obtenue en réalisant séparément les premier et deuxième niveaux 114, 116, puis en les solidarisant tels que les couches métalliques d'interconnexion 131 du BEOL du deuxième niveau 116 soient disposées du côté des couches métalliques d'interconnexion 124 du BEOL du premier niveau 114.

### Documents cités

S. Nalam et al., « 5T SRAM With Asymmetric Sizing for Improved Read Stability », IEEE Journal of Solid-State Circuits, Vol. 46, N°. 10, octobre 2011.
L. Chang et al., « An 8T-SRAM for Variability Tolerance and Low-Voltage Operation in High-Performance Caches », IEEE Journal of Solid-State Circuits, Vol. 43, N°. 4, avril 2008.
I.J. Chang et al., «A 32 kb 10T Sub-Threshold SRAM Array With Bit-Interleaving and Differential Read Scheme in 90 nm CMOS », IEEE Journal of Solid-State Circuits, Vol. 44, N°2, février 2009.
F. Andrieu et al., « Design Technology Co-Optimization of 3D-monolithic standard cells and SRAM exploiting dynamic back-bias for ultra-low-voltage operation », 2017 IEEE International Electron Devices Meeting (IEDM).

## Revendications

1. Dispositif mémoire (100) comprenant au moins :
- une matrice (102) de plusieurs lignes et colonnes de cellules mémoires formant des bits de mémorisation de données, chacune des cellules mémoires comportant au moins un transistor (144, 146, 148, 150, 156, 158) FET incluant au moins un élément électriquement conducteur (166, 168, 170) de polarisation arrière, la matrice (102) comprenant en outre au moins une colonne (104.1, 104.2) de cellules mémoires formant des premiers bits de commande de polarisation arrière ;
- un premier circuit de polarisation arrière (106) configuré pour délivrer en sortie des premières tensions de polarisation arrière dont les valeurs dépendent de celles des premiers bits de commande de polarisation arrière ;
- des premiers éléments de couplage (108), couplant électriquement des points mémoires des cellules mémoires formant les premiers bits de commande de polarisation arrière avec le premier circuit de polarisation arrière (106) ;
- des deuxièmes éléments de couplage (110), couplant électriquement le premier circuit de polarisation arrière (106) avec les éléments électriquement conducteurs (166, 168, 170) de polarisation arrière des cellules mémoires formant les bits de mémorisation de données ;
et dans lequel :
- le dispositif mémoire (100) forme un circuit 3D comprenant au moins des première et deuxième couches actives semi-conductrices (122, 130) entre lesquelles plusieurs couches métalliques d'interconnexions (124, 133, 135) sont empilées ;
- les premiers et/ou deuxièmes éléments de couplage (108, 110) comportent des portions métalliques (137, 141) d'au moins une des couches métalliques d'interconnexions (133, 135).

2. Dispositif mémoire (100) selon la revendication 1, dans lequel la matrice (102) est réalisée dans la deuxième couche active (130), et le premier circuit de polarisation arrière (106) est réalisé dans au moins l'une des première et deuxième couches actives (122, 130).

3. Dispositif mémoire (100) selon l'une des revendications précédentes, dans lequel la première couche active (122) fait partie d'un substrat comportant une couche support (118), la première couche active (122) étant disposée entre la couche support (118) et la deuxième couche active (130).

4. Dispositif mémoire (100) selon l'une des revendications précédentes, dans lequel :
- les premiers éléments de couplage (108) comportent des portions métalliques (137) d'une des couches métalliques d'interconnexions appelée dernière couche métallique d'interconnexions (133) et qui correspond à celle, parmi lesdites couches métalliques d'interconnexions (124, 133, 135), qui est la plus proche de la deuxième couche active (130), et les deuxièmes éléments de couplage (110) comportent des portions métalliques (141) d'une des couches métalliques d'interconnexions appelée avant-dernière couche métallique d'interconnexions (135) et qui est disposée entre la dernière couche métallique d'interconnexions (133) et toutes les autres couches métalliques d'interconnexions (124), ou
- les premiers et deuxièmes éléments de couplage (108, 110) comportent des portions métalliques (137, 141) de la dernière couche métallique d'interconnexions (133).

5. Dispositif mémoire (100) selon l'une des revendications précédentes, dans lequel les éléments électriquement conducteurs (166, 168, 170) de polarisation arrière sont indépendants d'une ligne de cellules mémoires à l'autre.

6. Dispositif mémoire (100) selon l'une des revendications précédentes, dans lequel les éléments électriquement conducteurs (166, 168, 170) de polarisation arrière comportent des caissons de semi-conducteur dopé.

7. Dispositif mémoire (100) selon la revendication 6, comportant en outre plusieurs lignes de mot (160) telles que les cellules mémoires formant les bits de mémorisation de données et disposées sur une même ligne de la matrice (102) comportent des transistors d'accès (156, 158) dont les grilles sont couplées à une même ligne de mot (160), et dans lequel les caissons de semi-conducteur dopé selon un même type de conductivité et inclus dans des transistors de cellules mémoires d'une même ligne de la matrice (102) sont couplés électriquement entre eux et à au moins une sortie du premier circuit de polarisation arrière (106) par au moins l'un des deuxièmes éléments de couplage (110) tels qu'une même tension de polarisation arrière puisse être appliquée sur lesdits caissons de semi-conducteur dopé.

8. Dispositif mémoire (100) selon la revendication 7, dans lequel les premiers bits de commande de polarisation arrière sont formés par des cellules mémoires d'une ou plusieurs colonnes (104.1, 104.2) adjacentes formant un premier bord de la matrice (102) à côté duquel est disposé le premier circuit de polarisation arrière (106).

9. Dispositif mémoire (100) selon la revendication 8, dans lequel :
- les cellules mémoires d'au moins une colonne (172) formant un deuxième bord de la matrice (102) qui est opposé au premier bord de la matrice (102) correspondent à des bits de commande de fin de lecture dont les transistors d'accès sont couplés à au moins une ligne de mot distincte de celles auxquelles les transistors d'accès (156, 158) des cellules mémoires formant les bits de mémorisation sont couplés ;
- les cellules mémoires formant les bits de commande de fin de lecture sont couplées électriquement à un circuit de commande de fin de lecture (176) des bits de mémorisation de données ;
- les caissons de semi-conducteur dopé selon un même type de conductivité et inclus dans les transistors des cellules mémoires formant les bits de commande de fin de lecture sont couplés électriquement entre eux par des troisièmes éléments de couplage (174) comportant des portions métalliques (178) d'au moins une des couches métalliques d'interconnexions (124, 133, 135).

10. Dispositif mémoire (100) selon la revendication 9, dans lequel les portions métalliques (178) des troisièmes éléments de couplage (174) correspondent à des portions de la même couche métallique d'interconnexions (133, 135) que celle ou l'une de celles formant les portions métalliques (137, 141) des premiers et/ou deuxièmes éléments de couplage (108, 110).

11. Dispositif mémoire (100) selon l'une des revendications précédentes, comportant en outre :
- au moins un bloc d'entrées / sorties (186) auquel les colonnes des cellules mémoires formant les bits de mémorisation de données sont couplées électriquement ;
- un deuxième circuit de polarisation arrière configuré pour délivrer en sortie des deuxièmes tensions de polarisation arrière dont les valeurs dépendent de celles de deuxièmes bits de commande de polarisation arrière formés par au moins une ligne de la matrice (102) ;
- des quatrièmes éléments de couplage (188), couplant électriquement des points mémoires des cellules mémoires formant les deuxièmes bits de commande de polarisation arrière avec le deuxième circuit de polarisation arrière, et comportant des portions métalliques (190) de la même couche métallique d'interconnexions (133, 135) que celle ou l'une de celles formant les portions métalliques (137, 141) des premiers et/ou deuxièmes éléments de couplage (108, 110) ;
et dans lequel le deuxième circuit de polarisation arrière est couplé à des éléments électriquement conducteurs de polarisation arrière de transistors de type FET du bloc d'entrées / sorties (186).

12. Dispositif mémoire (100) selon la revendication 11, dans lequel les deuxièmes bits de commande de polarisation arrière sont formés par des cellules mémoires d'une ou plusieurs lignes (184.1, 184.2) adjacentes formant un troisième bord de la matrice (102) à côté duquel est disposé le deuxième circuit de polarisation arrière.

13. Dispositif mémoire (100) selon l'une des revendications 9 ou 10, et selon l'une des revendications 11 ou 12, dans lequel les troisièmes éléments de couplage (174) couplent électriquement les éléments électriquement conducteurs de polarisation arrière des transistors des cellules mémoires de ladite au moins une colonne (174) formant le deuxième bord de la matrice (102) avec le deuxième circuit de polarisation arrière.

14. Dispositif mémoire (100) selon l'une des revendications précédentes, dans lequel les cellules mémoires de la matrice (102) sont de type SRAM, ou CAM, ou TCAM, ou DRAM, ou ROM.
